Europäisches Patentamt

European Patent Office

Office européen des brevets

(19)

(11) EP 1 337 045 A1

(12) **EUROPEAN PATENT APPLICATION**

(43) Date of publication:
20.08.2003 Bulletin 2003/34

(51) Int Cl.$^7$: **H03M 13/27**

(21) Application number: 02003671.1

(22) Date of filing: 18.02.2002

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **SIEMENS AKTIENGESELLSCHAFT**
**80333 München (DE)**

(72) Inventor: **Xu, Wen, Dr.**
**82008 Unterhaching (DE)**

(54) **Method for interleaving and deinterleaving a digital signal and application of these methods**

(57) Method for interleaving a digital signal S consisting of data symbols comprising the steps of

- Constructing at least two subsets of the data symbols,
- Performing a random permutation on a selection of these subsets,

- Appending all subsets to each other to form an altered signal S' such, that subsets on which a permutation is performed alternate with subsets on which no permutation is performed.

## FIG 2

| 3×4 Block interleaver LR/TB | i | 0 | 1 | 2 | 3 | 4 | 5 | 6 | 7 | 8 | 9 | 10 | 11 | S-parameter |
|---|---|---|---|---|---|---|---|---|---|---|---|---|---|---|---|
| | $\pi_i$ | 0 | 4 | 8 | 1 | 5 | 9 | 2 | 6 | 10 | 3 | 7 | 11 | 3 |
| a) Permutation within $\{\pi_i, \pi_{i+1}\}$ (i=0, 3, 6, ...) ($n_p$=2, $n_n$=1) | $\pi_i$ | 0 | 4 | 8 | 5 | 1 | 9 | 2 | 6 | 10 | 7 | 3 | 11 | 2 |
| b) Permutation within $\{\pi_i, \pi_{i+1}\}$ (i=1, 4, 7, ...) ($n_p$=2, $n_n$=1) | $\pi_i$ | 0 | 8 | 4 | 1 | 9 | 5 | 2 | 6 | 10 | 3 | 11 | 7 | 2 |
| c) Permutation within variable local areas ($n_p$=1~2, $n_n$=2~3) | $\pi_i$ | 4 | 0 | 8 | 1 | 5 | 9 | 2 | 6 | 3 | 10 | 7 | 11 | 2 |
| d) Permutation sequentially within $\{\pi_i, \pi_{i+1}\}$ (i=0,1, 2, ...) ($n_p$=2, $n_n$-1) | $\pi_i$ | 4 | 8 | 0 | 1 | 5 | 9 | 6 | 10 | 2 | 7 | 11 | 3 | 1 |

EP 1 337 045 A1

## Description

## Background of the Invention

The present invention deals with a method for interleaving and a method for deinterleaving digital signals. In particular the interleaving is done such, that burst errors and periodic errors can be corrected likewise.

Interleaving is the process of rearranging the ordering of a sequence of binary or non-binary data symbols in an one-to-one deterministic manner. The reverse of this process is called deinterleaving. A deinterleaver is an interleaver that acts on the output of the interleaver and puts the symbols back into the original order. Interleaving is performed by separating neighboured data symbols for the transmission in order to be able to compensate errors that occurred during the transmission.

In many applications in communication technology, interleaving is used in conjunction with channel coding to enhance correction performance. The channel coding mentioned here includes not only the classical (forward error correction) block and convolutional codes, but also modulation and any combination of them, such as concatenated coding and modulation. Most block or convolutional codes are designed to combat random, independent errors usually occurring in a channel without memory. For channels with memory such as mobile channels, burst channel errors are observed due to fading which varies depending on mobile speed, propagation delay spread and frequency. Interleaving is deployed to disperse the burst errors when the received signal level fades, and to reduce the concentration of the errors that must or should be corrected by the channel code. In serial or parallel concatenated coding, such as the so-called Turbo codes, an interleaver which is then called the (internal) Turbo interleaver is embedded to disperse burst errors generated by the first stage of decoding (e.g. Viterbi algorithm). In some circumstances, an interleaver is also called a permutator or a scrambler.

Structured Block/Convolutional Interleavers

The interleavers most commonly used in practice are block and convolutional (periodic) interleavers [Steele & Hanzo 99]. Due to the well-defined structure, these interleavers, in contrast to the random interleaver, are referred to as structured interleavers. A block interleaver takes a block of symbols and writes them by rows into a matrix with R rows and C columns. After the matrix is filled, the symbols are read out and fed to the modulator one column at a time. At the receiver, the deinterleaver performs the inverse permutation of the matrix by feeding in one column at a time until the matrix is filled, and reading out the symbols a row at a time.

Suppose for an array of input data x[i] (i = 0, 1,..., T-1), the output of an interleaver is y[i]. Then, the interleaver is in general a permutation $\Pi$: $y[i] = x[\pi_i]$ (i, $\pi_i \in \{0, 1,..., T-1\}$)

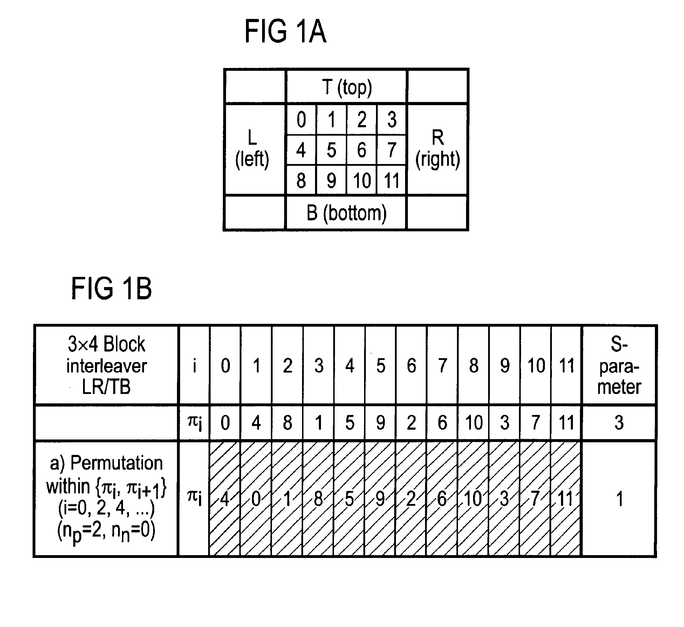

The example in fig. 1 A shows a classical block interleaver with T = R x C = 3 x 4 = 12. Suppose for this block interleaver the input data written in rows (from left to right). There are two orders in which the columns of the matrix can be read out (i.e. LR: left-to-right, and RL: right-to-left) and two orders in which rows are read out (i.e. TB: top-to-bottom, and BT: bottom-to-top). This results in a total of 4 interleaving schemes: LR/TB, LR/BT, RL/TB and RL/BT. E.g. the original order of the data symbols was read row-wise from left to right (LR: left to right): 0, 1, ..., 11. After the structured interleaving with the scheme LR/TB column-wise from top to bottom: 0,4,8,1,5,9,2,6,10,3,7,11. After deinterleaving the original order of the data symbols is restored. For a sequence of data blocks, the same interleaver is used for each block, such as the typical 10 ms blocks of data in UMTS [3GPP TS 25.212].

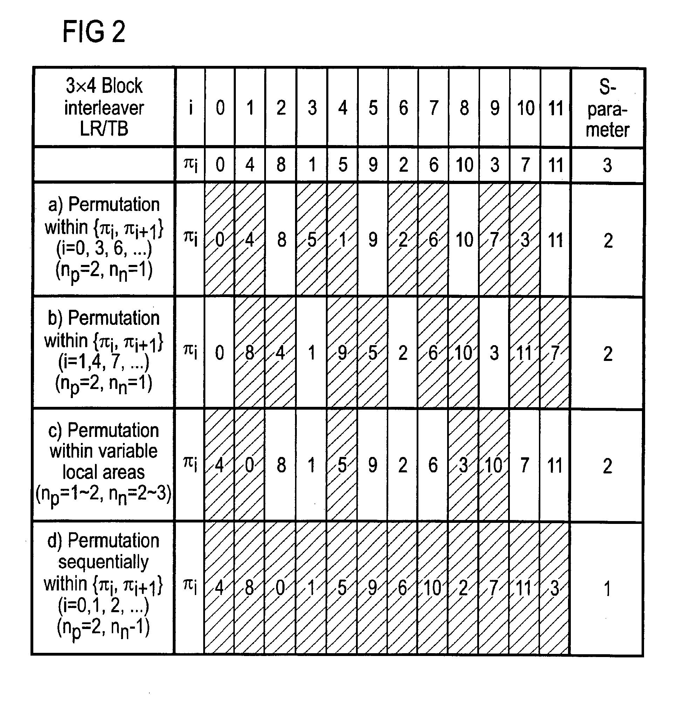

Suppose for an array of input data x[i] (i = 0, 1,..., T-1), the output of an interleaver is y[i]. Then, the interleaver is in general a permutation $\Pi$: $y[i] = x[\pi_i]$; (i, $\pi_i \in \{0, 1,..., T-1\}$), that is, each entry i is mapped to a $\pi_i$ of the same definition range $\{0, 1,...,T-1\}$. One says that an interleaver has a spreading factor (s, t), if wherever $|i - j| < s$, then $|\pi_i - \pi_j| \geq t$, or equivalently if wherever $|\pi_i - \pi_j| < t$, then $|i - j| \geq s$. For the ordered i = 0, 1, ..., T-1, this is equivalent to $|\pi_{i+k} - \pi_i| \geq t$ for k = 1, 2, ..., s-1, i. e. any two entries i, i+k within a neighbourhood of s entries are, after interleaving, separated into two positions of a distance at least t. Here we denote the separation or the distance of two data with s, and the length of a burst of symbols (on which e.g. burst errors occur) with t. With such a definition, the individual symbols in a burst of length smaller than t at the input will be separated at the output into distinct blocks of length greater than or equal to s. If an interleaver has a spreading factor (s, t), then the corresponding deinterleaver has a spreading factor (t, s). The maximum value s for any s ≤ t is called the s-parameter. Thus the s-parameter can be defined as min{s, t} and it denotes, as already explained above, the separation of originally neighboured data symbols. For example, in fig. 2a) the data symbol '2' is located at position 6, two positions behind the data symbol '1' at position 4, thus the s-parameter is 2.

Generally, the minimum separation of any two errors in the burst of length t can be characterized by the s-parameter, which is one of the most important parameters to describe the capability of burst error dispersion of an interleaver. Grossly speaking, the greater the s-parameter, the higher the burst error dispersion capability.

To recapitulate, a block interleaver is well structured and can usually disperse relatively long burst errors. In fact, a classical R x C block interleaver has usually an s-parameter min{R, C}. Several block interleavers have been specified in mobile communication standards, such as GSM, IS-95, and UMTS (e.g. [GSM 05.03], [3GPP TS 25.212]).

Random Interleavers:

The classical use of interleaving is to randomize the locations of errors introduced in transmission, allowing the use of random error correcting codes. The performance of a channel coding scheme, especially for the Turbo codes (concatenated codes) at relatively high channel SNR (SNR: Signal to Noise Ratio), can be further improved by using a random interleaver [Hagenauer et al. 94]. A random interleaver can be considered as a special block interleaver based on a random permutation. The data are written to the memory in sequential order and read out in a random order. Concretely, a vector of random numbers is first generated, e.g., by using a random noise source, and sorted in increasing/decreasing order. The sorted order is then used to generate the interleaver.

Unfortunately, a real random interleaver is difficult to realize. In addition, it has also a quite small s-parameter which theoretically approaches 1. For Turbo codes, the error correction performance improves very slowly at high SNR when SNR increases and may reach a saturation, i.e. the error rate after Turbo decoding does not approach 0 even for arbitrarily high channel SNR (error floor) [Robertson 94], even with a random interleaver used. For this reason, a method was proposed in [Dolinar and Divsalar 95] to generate, by means of global search, the so-called s-parameter random interleaver, a random interleaver with an s-parameter constraint. By employing the s-parameter random interleaver in the Turbo code, further performance can be achieved by removing the error floor at high channel SNR.

Recapitulating, random interleaver can account for periodically occurring errors.

Combination of structured and Random Interleavers:

A well-structured interleaver like a block interleaver has a high capability to disperse burst errors, but may fail for periodically-spaced, or other structured errors. In the worst case, it can even convert non-burst errors into a burst error, so that the performance of the channel coding may even be deteriorated. By introducing certain random permutations in a structured interleaver, not only the burst errors but also the otherwise structured errors can be tackled. This combination of structured and random interleaving has both the advantage of a structured interleaver (like a block interleaver), namely the high capability to disperse burst errors, and the advantage of random permutation (like a random interleaver). In addition, it can be easily realized.

In [US 4,547,887], a pseudo-random permutator (random interleaver) is interposed between the fixed (structured) convolutional interleaver and the transmission channel. The permutator divides the output sequences of the fixed interleaver into sub-sequences or data blocks, and then permutes the order at which the bits of each data block are transmitted in a pseudo-random manner.

A possible result of this procedure is shown in fig. 1B: For the data symbols i = 1-11 a 3 x 4 block interleaver (LR/TB) is performed and thus yields the respective $\pi_i$. Now a random permutation of two, at this stage neighboured data symbols is performed. However, as can be seen from fig. 1 B the consequence can be, that originally neighboured bits are still neighboured for transmission, as it is the case here for 0 and 1.

In general, the drawback of this process is that due to the random permutation in each block, the output sequence of the combined fixed interleaver and random permutator will, like a conventional random interleaver, have most likely a trivial 's-parameter' theoretically approaching 1. Thus, it will not ensure any high capability to disperse burst errors.

As real random permutations have a rather high computing complexity, they are most commonly replaced by pseudo random permutations. This is being explained in more detail in respect with the preferred embodiments.

## Brief Description of the Invention

It is one object of the invention to provide an interleaving method with high capabilities in both burst error dispersion and data randomisation.

Subsets SS from the original signal S are chosen, on which a random permutation is performed. The size or length of these subsets is denoted with $n_p$. Between these subsets with a random permutation, further subsets with a size or length $n_n$ are selected, on which no permutation is performed.

Formally there are three alternatives to be distinguished:

Alternative I) $n_n = 0$:

This means, that no subsets with no permutation are introduced in between the subsets, on which a permutation is performed.

Surprisingly, the simulations have shown already improved results by simple changing the order from

i) structured interleaving on the whole data set followed by random permutation on subsets (state of the art)

to

ii) first forming subsets on which random permutations are performed followed by a structured interleaving on the whole data set.

A possible reason is that the randomness introduced in limited areas is spread over the whole signal. Notice that this alternative can be considered as a special case of the alternative II) in which subsets on which no permutation is performed contain no data symbols.

## Alternative II) $n_n > 0$:

In contrast to alternative I), subsets on which a random permutation is performed alternate with subsets on which no permutation is performed. This alternation can ensure that no originally neighboured data symbols are placed neighboured for transmission.
In this case, a desirable s-parameter can be generated for both of the interleaving steps (see i), ii) described in Al-ternative I).

## Alternative III) $n_n < 0$:

This means, that the subsets, on which a permutation is performed overlap. A realisation example is shown in fig. 2d). Here in the overlap region the data symbols experience more than one permutation. This can also ensure a separating of data symbols, which are neighboured after the structured interleaver.

## Short description of the drawings

The features, objects, and advantages of the present invention will become more apparent from the detailed description set forth below when taken in conjunction with the drawings wherein:

Fig. 1 A    shows a classical block interleaver (prior art),

Fig. 1 B    a realisation example of the method proposed in [US 4,547,887],

Fig. 2,3    show examples of a classical 3x4 block interleaver followed by local random permutations. The size of the permutations ($n_p$) or non-permutation areas ($n_n$) is varied in Fig. 2 and Fig. 3. The difference between Fig. 2 and Fig. 3 is the procedure of the block interleaver (LR/TB or RL/TB in Fig. 2 or Fig. 3, respectively).

Fig. 4    shows in the examples a), b) the outcome of a structured interleaving performed after the random interleaving on individual subsets.

Fig. 5,6    illustrate the change of s-parameter from an original $s_0$ of the structured interleaver to a new $s_{perm}$ when local random permutation is introduced.

## Detailed description of the preferred embodiments

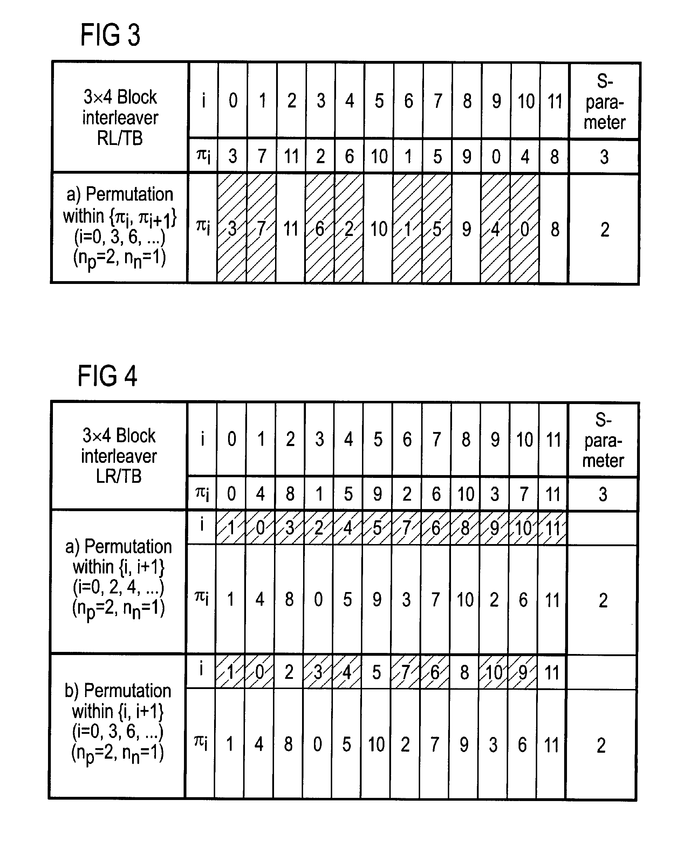

Structured Interleaving before Random Interleaving (cf. Fig. 2, 3; alternative II, III)

In Fig. 2 various results of a classical 3x4 block interleaver (LR/TB), as shown in Fig. 1, followed by local random permutations are shown.
i = 0,1, ...,11 denote the data symbols forming the original signal S. A structured permutation (LR/TB) is performed, thus yielding $\pi_i$ = 0,4,8,1,...3,7,11. From this row $\pi_i$ of data subsets of the size $n_p$ are chosen, on which a random permutation is performed (grey areas). These subsets alternate with other subsets or areas of size $n_n$ on which no random permutation is carried out (white areas).
The examples a)-c) refer to various sizes $n_n$, $n_p$ of the respective areas.
For every permutation as a result the minimum separation of data symbols i, j is shown in the row 's-parameter', which was defined above.
Even if the s-parameter is maximum when only a structured permutation is performed, one should keep in mind, for instance, that using a structured interleaver alone may not be able to deal with periodically occurring errors.
Obviously with a random permutation the previous order of the data symbols can be restored, cf. Fig. 2a): After the structured interleaving the order of the data symbols is 0,4,8,5,1... after the random interleaving the order is 0,4,8,1,5,... An effective or real permutation has taken place only with the data symbols 1,5. In the figures the bold written numbers are $\pi_i$ or i where a permutation really (randomly) has occured.
This clearly shows that a structured interleaver (like a block interleaver) can be enhanced by introducing local random permutations for subsets or portions of the data, thus aiming at high capabilities in both burst error dispersion and data randomization.
For the embodiment in Fig. 2, the structured interleaving is performed first, thus forming an altered Signal S', then at least one subset SS is chosen from S', which undergoes a random permutation thus resulting in an altered subset SS'. This at least one altered subset SS' is put together to form the signal S'' to be transmitted.
At the receiver side the process is reversed to restore the original signal S.
In Fig.3 only the performance of the structured interleaver is changed to RL/TB in contrast to LR/TB in Fig.2. If comparing Fig.2a) and Fig.3a) a similar effect on the s-parameter can be seen.

Structured Interleaving after Random Interleaving (cf. Fig. 4, alternative I, II, III)

In this case, at least one subset SS is taken from the original signal, within this at least one subset SS a random permutation is performed, which leads to an altered subset SS'. After this at least one subset is put together in order to reconstruct a signal S' of the same length as the original signal S. This signal S' undergoes a structured interleaving, thus creating a signal S'' which is transmitted. Examples for structured interleaving after random interleaving on at least one subset are shown in Fig. 4. In the examples shown in Fig. 2 a), b) and Fig. 4 a),b) respectively, the order of the interleaving steps (structured, random interleaving) does not provoke an effect on the s-parameter.

To summarise, since the random permutation is restricted in certain local areas, the resulting interleaver has a non-trivial s-parameter, which is determined by the size of the local permutation/non-permutation areas. Thus the resulting interleaver can effectively disperse the burst errors as well. With the random permutation, it can also tackle other structured errors.

Realisations of the Random Permutation and the Interleaver

The random permutation, i.e. whether and how the neighbouring data are permuted, can, as in the case of a normal random interleaver, be controlled by a set of random numbers or pseudo noise (PN) sequence. The pseudo noise can, e.g., be generated by means of a linear feedback shift register (LFSR). In a CDMA (Code Division Multiple Access) system like UMTS (Universal Mobile Telecommunications System), binary PN sequences are already available (e.g. spreading codes, scrambling codes) and can be used to generate the random numbers for random permutation. In the frame of this document we use the expression 'random permutation' for both, real random permutation and pseudo random permutations.

The interleaver can be realized through a cascade, by either first employing a structured interleaver (then the local random permutation), or first employing a local random permutation (then the classical structured interleaver).

Applications of the Proposed Interleaving Method

The proposed interleaving method is generally applicable, e.g. as the internal interleaver in Turbo codes. Due to the randomness of the permutation, better performance can be achieved in comparison to a classical block interleaver. Wherever necessary, different interleaving (permutation) rules, thanks to the randomness, can be systematically realized for consecutive symbol blocks. For existing systems such as GSM (Global System for Mobile Communications) or UMTS where structured interleavers have already been standardized, local random permutations can be introduced or added to further improve the performance.

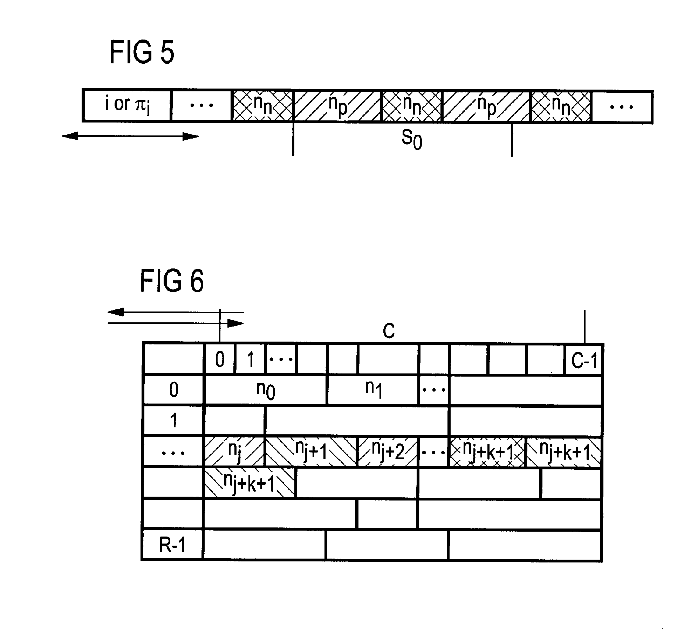

General Considerations on the s-parameter (cf. Fig. 5, 6)

a) Structured interleaver before local random permutation:

Consider a random permutation conducted periodically, say with a permutation period $n_p + n_n$, where $n_p$ = size of (random) permutation areas as defined before; $n_n$ = size of non-permutation areas ($n_n < 0$ means there is an overlap among permutation areas, as in the realization example d) in Fig. 2). Fig. 2, Fig. 3 and Fig. 4 show some examples for a 3x4 block interleaver before or after local permutations.

In Fig. 5 a row of data/symbol comprising areas with or without communications are depicted. For any given constants $n_p \geq 1$ and $n_n \geq 0$, and for any interleaver with an original s-parameter of a structured interleaver $s_0 > 0$, the interleaver with local random permutation within $n_p$ has in general an s-parameter

$$s_{perm} = 1 \text{ for } (s_0+1) \leq n_p$$

and

$$S_{perm} = \max \{0, (\lfloor (s_0+1-n_n)/(n_p+n_n) \rfloor - 1) (n_p+n_n)\}$$
$$+ \min \{(s_0+1-n_n) \bmod (n_p+n_n), (n_n+1)\}$$
$$\text{for } n_p < (s_0+1)$$

where x mod y denotes x modulo y. $n_p+n_n \geq 1$ is the permutation period. We see that, by carefully selecting $n_p$ and $n_n$, $s_{perm}$ can vary in a range from $s_0$, the maximum achieved for $n_p = 1$ (no permutation), to 1 (the minimum). In order to ensure $s_{perm} > 1$, it is necessary to have $n_p < (s_0+1)$. Thus in the examples in Fig.2-4 where a 3 x 4 block interleaver was used, whose $s_0 = \min (R, C) = 3$, we have chosen $n_p \leq 2$.

Notice that any interleaver or deinterleaver having an s-parameter $s_0$ has a spreading factor $(s_0, s_0)$. In other words, the individual symbols in a burst of length smaller than $s_0$ at the input (of the interleaver or deinterleaver) will be separated at the output into distinct blocks of length greater than or equal to $s_0$.

Note that the greater $s_{perm}$ is, the error burst of greater size can be dispersed. The greater $n_p$ and the smaller $n_n$, the more randomness the permutation can provide. E.g. for an RxC block interleaver with $s_0 = \min \{R, C\} = 50$, we can choose $(n_p+n_n) < (s_0+1) = 51$, then we have

$$s_{perm} = \max \{0, (\lfloor (51-n_n)/(n_p+n_n) \rfloor - 1) (n_p+n_n)\}$$
$$+ \min \{(51-n_n) \bmod (n_p+n_n), (n_n+1)\}$$

If a relatively large permutation area $n_p$ is desirable such that $25 < (n_p+n_n)$, we have

$$s_{perm} = n_n + 1$$

When the burst statistics of the input data requires that all error bursts of length smaller than or equal to 26 be dispersed (i.e. $s_{perm} \geq 26$), than we can choose $n_p = n_n = 25$. This results in $s_{perm} = 26$.

The parameters $n_p$ (size of the random permutation area) and $n_n$ (size of the non-permutation area) need not to be constant within the array of the input data, i.e. the permutation period can vary (see examples in Fig. 2, Fig. 5). In this case, the maximum of $n_p$ and the minimum of $n_n$ will mainly determine the s-parameter $s_{perm}$. The basic idea is that $n_p$ and $n_n$ should be selected in conjunction with the channel coding such that the best or desirable performance of the combined interleaving and channel coding can be achieved.

b) Structured interleaver after local random permutation:

Let us consider the case in which a block interleaver after local permutations. For simplicity, suppose $s_0 = \min\{R, C\} = R$.

As shown in Fig. 6, when the size of the minimum local (random) permutation area $n_j \geq C$, then it is easy to see $s_{perm} = 1$. Otherwise when $n_j < C$, but the sum of sizes of any successive local areas $n_j + n_{j+1} > C$ (i.e. they cannot be fit into one row and span into two adjacent rows), then at least one data in $n_j$ and one data in $n_{j+1}$ belong to one column after the block interleaving, therefore the random permutation within $n_j$ and $n_{j+1}$, followed by the block interleaving will lead to a trivial s-parameter $s_{perm} = 1$. Note that for simplicity, we use $n_j$ to denote the size of the local area as well as the area itself.

For $n_j + n_{j+1} \leq C$, any data in $n_j$ and/or $n_{j+1}$ will be block-interleaved into two different columns. But for the following permutation area $n_{j+2}$, as far as $n_j + n_{j+1} + n_{j+2} > C$, then one data in $n_j$ and one data in $n_{j+2}$ belong to one column after the block interleaving, thus the whole interleaving has a spreading factor $(s, t) = (n_{j+1} + 1, R)$. In general, for all $j = 0, 1, ...$ and $k = 0, 1,... (k = 0$ corresponds to $n_j + n_{j+1} > C$), when $n_j + n_{j+1} +... + n_{j+k} \leq C$ and $n_j + n_{j+1} +... + n_{j+k} + n_{j+k+1} > C$, then $(s, t) = (n_{j+1} +... + n_{j+k} + 1, R)$. This leads to an s-parameter of the combined local permutation and block interleaving

$$s_{perm} = \min \{n_{j+1} +... + n_{j+k} + 1, s_0\}, \text{ subject to all } j \text{ and}$$

k.

Take, for instance, $n_j = n_{j+3} = ... = \lfloor C/2 \rfloor$, $n_{j+1} = n_{j+4} = ... = \lfloor C/3 \rfloor$, $n_{j+2} = n_{j+5} = ... = \lfloor C/4 \rfloor$, then we have $k = 1$, and $s_{perm} = \lfloor C/4 \rfloor + 1$, where $\lfloor x \rfloor$ is the integer part of x. For $n_j = n_{j+1} = ... = n_{j+k} = \lfloor C/(k+1) \rfloor$, then $s_{perm}$

$= \min \{\lfloor kC/(k+1) \rfloor + 1, s_0\}$. The maximum of $s_{perm}$ will be reached, at least for $k = C-1$, i.e. $n_j = n_{j+1} = ... = n_{j+k} = 1$. Notice that $s_{perm}$ can vary in a range from $s_0$ (the maximum achieved e.g. for $n_j = n_{j+1} = ...= n_{j+k} = 1$ (no permutation)) to 1 (the minimum which can be achieved for $n_j + n_{j+1} > C$).

E.g. for an RxC = 50x50 block interleaver with $s_0 = \min\{R, C\} = 50$. When the burst statistics of the input data requires that all error bursts of length smaller than $s_{perm} = 26$ be dispersed, than we can choose $n_j = 25$ for all j = 0, 1, ... For RxC = 25x50 with $s_0 = \min\{R, C\} = 25$, we can choose $n_j = 25$ for all j = 0, 1, ... to obtain $s_{perm} = s_0 = 25$, the s-parameter of the block interleaver.

As in the case of the structured interleaver before local random permutation, some local areas can be set to the non-permutation areas whenever desirable (e. g. for a greater $s_{perm}$), as shown in Fig. 4.

An advantage of structured interleaver after local random permutation over structured interleaver before local random permutation is its better randomisation capability for the input data. Thanks to the following block interleaving applied to the whole data, the local randomness within $n_j$ data is spread over $n_j$ columns of data. Consequently, better performance can be obtained, as confirmed in our simulations for Turbo codes.

Further Realisations and Applications

For the above mentioned local permutation 'local' does not necessarily mean that the data (symbols) are located directly or adjacently in neighbourhood. It can be in general any subset or combination of the subsets of the data located in different positions.

The size of the local permutation/non-permutation area, as well as the starting point, can be varied also randomly to some extent, as far as the capability in dispersing burst errors (i.e. $s_{perm}$) is ensured.

The random permutation described here means in practice, due to the implementability, pseudo-random or irregular permutation, which can be realized e.g. by using a fixed (pseudo-random) permutation table.

The proposed method can be easily applied to any structured interleavers, such as convolutional interleavers. A further example would be the application in 3GPP Turbo coding.

**References**

[3GPP TS 25.212] 'Technical Specification Group Radio Access Network; Multiplexing and channel coding (FDD) (Rel. 4),' 06.2001.

[GSM 05.03] GSM 05.03, 'Digital cellular telecommunications system (Phase 2+); Channel coding,' Rel. 1999, 2000.

[Dolinar and Divsalar 95] S. Dolinar and D. Divsalar, 'Weight distributions for Turbo codes using random and nonrandom permutations,' TDA Progress Report 42-121, JPL, Aug. 1995.

[Hagenauer et al 94] J. Hagenauer, P. Robertson and L. Papke, 'Iterative (Turbo) decoding of systematic convolutional codes with the MAP and SOVA algorithms,' ITG Fachbericht 130, Coding für Quelle, Kanal und Übertragung, pp. 21-29, 1994.

[Robertson 94] P. Robertson, 'Illuminating the structure of code and decoder of parallel concatenated recursive systematic (Turbo) codes,' Proc. Globecom'94, pp. 1298 - 1303, 1994.

[Stelle & Hanzo 99] R. Steele and L. Hanzo, Mobile Radio Communications (2nd Ed.), Ch. 4.2 'Interleaving Techniques', John Wiley & Sons, Ltd, 1999.

[US 4,547,887] US Patent, 'Pseudo-random convolutional inter-leaving,' Oct. 15, 1985.

## Claims

1. Method for interleaving a digital signal S consisting of data symbols comprising the steps of

   - Constructing at least two subsets of the data symbols,
   - Performing a random permutation on a selection of these subsets,
   - Appending all subsets to each other to form an altered signal S' such, that subsets on which a permutation is performed alternate with subsets on which no permutation is performed.

2. Method according to claim 1, where a structured interleaving is performed on the signal S'.

3. Method according to claim 1 or claim 2, where a structured interleaving is performed on the Signal S.

4. Method according to any preceding claim,

   - Where $n_p$ is the length of the subset on which a permutation is performed
   - Where $n_n$ is the length of the subset on which no permutation is performed and
   - where $n_p$ and $n_n$ are constant.

5. Method for interleaving and deinterleaving a digital signal transmitted over a transmission channel, said method comprising the steps of:

   a) an interleaving method according to any of the preceding claims,
   b) transmitting said interleaved data symbols over the transmission channel,
   c) receiving said interleaved bits,
   d) performing the complementary steps to the interleaving method according to any of the preceding claims in reverse chronological order such that the original digital signal S is restored.

6. Method for interleaving a digital signal S consisting of data symbols comprising the steps of

   - Selecting from the data symbols at least one first subset of length $n_p$,
   - Selecting at least one second subset of length $n_n$,
   - Performing a random permutation on the first subset,
   - Appending all subsets to each other to form an altered signal S'
   - Performing structured interleaving on the signal S'.

7. Method according to claim 6, where no random permutation is performed on the second subset.

8. Method according to claim 6 or 7, where the length $n_n$ of the second subset is zero or the second subset does not contain data symbols.

9. Application of the method according to any preceding claim in conjunction with channel coding.

10. Application of the method according to any preceding claim in concatenated coding, especially for a Turbo code.

## FIG 1A

| | T (top) | | | | |
|---|---|---|---|---|---|
| L (left) | 0 | 1 | 2 | 3 | R (right) |
| | 4 | 5 | 6 | 7 | |
| | 8 | 9 | 10 | 11 | |
| | B (bottom) | | | | |

## FIG 1B

| 3×4 Block interleaver LR/TB | $i$ | 0 | 1 | 2 | 3 | 4 | 5 | 6 | 7 | 8 | 9 | 10 | 11 | S-para-meter |
|---|---|---|---|---|---|---|---|---|---|---|---|---|---|---|
| | $\pi_i$ | 0 | 4 | 8 | 1 | 5 | 9 | 2 | 6 | 10 | 3 | 7 | 11 | 3 |
| a) Permutation within $\{\pi_i, \pi_{i+1}\}$ ($i=0, 2, 4, ...$) ($n_p=2$, $n_n=0$) | $\pi_i$ | 4 | 0 | 1 | 8 | 5 | 9 | 2 | 6 | 10 | 3 | 7 | 11 | 1 |

## FIG 2

| 3×4 Block interleaver LR/TB | i | 0 | 1 | 2 | 3 | 4 | 5 | 6 | 7 | 8 | 9 | 10 | 11 | S-para-meter |
|---|---|---|---|---|---|---|---|---|---|---|---|---|---|---|
| | $\pi_i$ | 0 | 4 | 8 | 1 | 5 | 9 | 2 | 6 | 10 | 3 | 7 | 11 | 3 |
| a) Permutation within $\{\pi_i, \pi_{i+1}\}$ (i=0, 3, 6, ...) ($n_p$=2, $n_n$=1) | $\pi_i$ | 0 | 4 | 8 | 5 | 1 | 9 | 2 | 6 | 10 | 7 | 3 | 11 | 2 |
| b) Permutation within $\{\pi_i, \pi_{i+1}\}$ (i=1,4, 7, ...) ($n_p$=2, $n_n$=1) | $\pi_i$ | 0 | 8 | 4 | 1 | 9 | 5 | 2 | 6 | 10 | 3 | 11 | 7 | 2 |
| c) Permutation within variable local areas ($n_p$=1~2, $n_n$=2~3) | $\pi_i$ | 4 | 0 | 8 | 1 | 5 | 9 | 2 | 6 | 3 | 10 | 7 | 11 | 2 |
| d) Permutation sequentially within $\{\pi_i, \pi_{i+1}\}$ (i=0,1, 2, ...) ($n_p$=2, $n_n$-1) | $\pi_i$ | 4 | 8 | 0 | 1 | 5 | 9 | 6 | 10 | 2 | 7 | 11 | 3 | 1 |

## FIG 3

| 3×4 Block interleaver RL/TB | i | 0 | 1 | 2 | 3 | 4 | 5 | 6 | 7 | 8 | 9 | 10 | 11 | S-para-meter |
|---|---|---|---|---|---|---|---|---|---|---|---|---|---|---|
| | $\pi_i$ | 3 | 7 | 11 | 2 | 6 | 10 | 1 | 5 | 9 | 0 | 4 | 8 | 3 |
| a) Permutation within $\{\pi_i, \pi_{i+1}\}$ (i=0, 3, 6, ...) ($n_p$=2, $n_n$=1) | $\pi_i$ | 3 | 7 | 11 | 6 | 2 | 10 | 1 | 5 | 9 | 4 | 0 | 8 | 2 |

## FIG 4

| 3×4 Block interleaver LR/TB | | i | 0 | 1 | 2 | 3 | 4 | 5 | 6 | 7 | 8 | 9 | 10 | 11 | S-para-meter |
|---|---|---|---|---|---|---|---|---|---|---|---|---|---|---|---|
| | | $\pi_i$ | 0 | 4 | 8 | 1 | 5 | 9 | 2 | 6 | 10 | 3 | 7 | 11 | 3 |
| a) Permutation within $\{i, i+1\}$ (i=0, 2, 4, ...) ($n_p$=2, $n_n$=1) | i | | 1 | 0 | 3 | 2 | 4 | 5 | 7 | 6 | 8 | 9 | 10 | 11 | |
| | $\pi_i$ | | 1 | 4 | 8 | 0 | 5 | 9 | 3 | 7 | 10 | 2 | 6 | 11 | 2 |
| b) Permutation within $\{i, i+1\}$ (i=0, 3, 6, ...) ($n_p$=2, $n_n$=1) | i | | 1 | 0 | 2 | 3 | 4 | 5 | 7 | 6 | 8 | 10 | 9 | 11 | |
| | $\pi_i$ | | 1 | 4 | 8 | 0 | 5 | 10 | 2 | 7 | 9 | 3 | 6 | 11 | 2 |

## FIG 5

| i or $\pi_i$ | $\cdots$ | $n_n$ | $n_p$ | $n_n$ | $n_p$ | $n_n$ | $\cdots$ |

$S_0$

## FIG 6

C

|  | 0 | 1 | $\cdots$ |  |  |  |  |  |  | C-1 |
|---|---|---|---|---|---|---|---|---|---|---|
| 0 | $n_0$ | | | $n_1$ | | $\cdots$ | | | | |
| 1 | | | | | | | | | | |
| $\cdots$ | $n_j$ | | $n_{j+1}$ | | $n_{j+2}$ | | $\cdots$ | $n_{j+k+1}$ | | $n_{j+k+1}$ |
| | $n_{j+k+1}$ | | | | | | | | | |
| | | | | | | | | | | |
| R-1 | | | | | | | | | | |

European Patent Office

# EUROPEAN SEARCH REPORT

Application Number

EP 02 00 3671

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | TANRIOVER C ET AL: "Multifold turbo codes" PROCEEDINGS. 2001 IEEE INTERNATIONAL SYMPOSIUM ON INFORMATION THEORY (IEEE CAT. NO.01CH37252), PROCEEDINGS. 2001 IEEE INTERNATIONAL SYMPOSIUM ON INFORMATION THEORY, WASHINGTON, DC, USA, 24-29 JUNE 2001, page 145 XP002209612 2001, Piscataway, NJ,USA, IEEE, USA ISBN: 0-7803-7123-2 | 1,4,5 | H03M13/27 |
| A | * the whole document * | 6,7,9,10 | |
| D,Y | DOLINAR S ET AL: "WEIGHT DISTRIBUTIONS FOR TURBO CODES USING RANDOM AND NONRANDOM PERMUTATIONS" JET PROPULSION LAB PROGRESS REPORT, XX, XX, 15 August 1995 (1995-08-15), pages 56-65, XP000863600 * the whole document * | 1,4,5 | |
| | | | TECHNICAL FIELDS SEARCHED (Int.Cl.7) |
| Y | US 4 394 642 A (RATTLINGOURD GLEN D ET AL) 19 July 1983 (1983-07-19) * figures 4,5 * * column 1, line 35 - line 40 * * column 5, line 39 - line 42 * * column 6, line 55 - line 61 * | 6,7,9 | H03M |
| Y | EP 0 952 673 A (NIPPON TELEGRAPH & TELEPHONE) 27 October 1999 (1999-10-27) * page 8, line 26 - line 34 * * page 9, line 42 - line 48 * | 6,7,9 | |
| A | * figure 7 * | 1,3-5,10 | |

-/--

The present search report has been drawn up for all claims

| Place of search | Date of completion of the search | Examiner |
|---|---|---|
| THE HAGUE | 12 August 2002 | Ogor, M |

EPO FORM 1503 03.82 (P04C01)

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 1 098 445 A (CANON KK) 9 May 2001 (2001-05-09) * page 2, line 42 - page 3, line 13 * * figures 10,11 * | 1,2,5,6, 9,10 | |
| A | EP 0 998 046 A (FUJITSU LTD) 3 May 2000 (2000-05-03) * figures 6-8 * * page 2, line 19 - page 3, line 26 * * page 7, line 12 - line 21 * | 1,2,4-6, 9 | |
| A | WO 00 19618 A (NORTEL NETWORKS CORP) 6 April 2000 (2000-04-06) * the whole document * | 1,4-6,9, 10 | |

**European Patent Office**

**EUROPEAN SEARCH REPORT**

Application Number

EP 02 00 3671

TECHNICAL FIELDS SEARCHED (Int.Cl.7)

The present search report has been drawn up for all claims

| Place of search | Date of completion of the search | Examiner |
|---|---|---|
| THE HAGUE | 12 August 2002 | Ogor, M |

## ANNEX TO THE EUROPEAN SEARCH REPORT
## ON EUROPEAN PATENT APPLICATION NO.

EP 02 00 3671

12-08-2002

| Patent document cited in search report | | Publication date | Patent family member(s) | | Publication date |
|---|---|---|---|---|---|
| US 4394642 | A | 19-07-1983 | NONE | | |
| EP 0952673 | A | 27-10-1999 | EP | 0952673 A1 | 27-10-1999 |
| | | | CN | 1246991 T | 08-03-2000 |
| | | | WO | 9925069 A1 | 20-05-1999 |
| EP 1098445 | A | 09-05-2001 | FR | 2800950 A1 | 11-05-2001 |
| | | | FR | 2805103 A1 | 17-08-2001 |
| | | | EP | 1098445 A1 | 09-05-2001 |
| | | | JP | 2001244822 A | 07-09-2001 |
| | | | US | 6404360 B1 | 11-06-2002 |
| EP 0998046 | A | 03-05-2000 | JP | 3257984 B2 | 18-02-2002 |
| | | | JP | 2000138596 A | 16-05-2000 |
| | | | EP | 0998046 A2 | 03-05-2000 |
| WO 0019618 | A | 06-04-2000 | BR | 9912531 A | 02-05-2001 |
| | | | CN | 1321364 T | 07-11-2001 |
| | | | EP | 1118160 A1 | 25-07-2001 |
| | | | WO | 0019618 A1 | 06-04-2000 |
| | | | US | 6427214 B1 | 30-07-2002 |